# EUROPEAN PATENT APPLICATION

(11) **EP 2 784 491 A1**
(43) Date of publication of application: **01.10.2014**
(21) Application number: 12851845.3
(22) Date of filing: 23.10.2012
(51) Int. Cl.: G01N 27/00

(54) **CRITICAL CURRENT MEASURING METHOD OF SUPERCONDUCTIVE CABLE**

(30) Priority: 24.11.2011 JP 2011256107
(71) Applicant: Sumitomo Electric Industries, Ltd., Chuo-ku Osaka-shi Osaka 541-0041 (JP)
(72) Inventor: OHYA, Masayoshi, Osaka-shi Osaka 5540024 (JP)
(74) Representative: Kreutzer, Ulrich
(86) International application number: PCT/JP2012/077309
(87) International publication number: WO 2013/077128

(57) **Abstract**

A coaxial superconducting cable includes a cable core having a plurality of superconducting layers (12A, 12B, 12C) arranged coaxially. When a superconducting layer (12C) located at an outer circumferential side of the cable core is taken as the target of measurement, a current-applying round route is developed with the superconducting layer (12C) corresponding to an outbound route and another superconducting layer corresponding to a return route. DC current is applied to the current-applying round route from a DC power supply (200), and the critical current of the superconducting layer (12C) is measured. The superconducting layer corresponding to the return route is selected such that the total of the design value of the critical current is greater than or equal to the design value of the critical current of the superconducting layer (12C) that is the target of measurement. Since the current conducted to the superconducting layer (12C) that is the target of measurement becomes less than or equal to the value of the current that can be applied to the return route for the measurement of the critical current, the critical current can be measured reliably. Thus, there can be provided a critical current measuring method of a superconducting cable allowing the critical current of an arbitrary superconducting layer in the coaxial superconducting cable to be measured accurately.

## Description

### TECHNICAL FIELD

The present invention relates to a method of measuring critical current of a superconducting cable. Particularly, the present invention relates to a method of measuring the critical current of a superconducting cable, allowing measurement of the critical current for an arbitrary superconducting layer in a multiphase (typically 3-phase) coaxial superconducting cable.

### BACKGROUND ART

The development of a superconducting cable as an electric power cable constituting an electric power supply route is proceeding. A typical example of a superconducting cable is: a single-core superconducting cable equipped with a cable core including a superconducting layer formed having superconducting wire of an oxide superconducting phase wound, and a heat insulating pipe storing one or a plurality of cable cores, filled with a coolant such as liquid nitrogen; or a multicore superconducting cable (Japanese Patent Laying-Open No. 2006-329838 (PTD 1)). For example, a 3-core superconducting cable used in 3-phase alternating current electric transmission includes 3 cable cores. The superconducting layer of each cable core is used for electric transmission of each phase. In addition, as a multiphase superconducting cable, research is now pursued on a coaxial superconducting cable utilizing each of a plurality of superconducting layers arranged coaxially for the electric transmission of each phase (Japanese Patent Laying-Open No. 2005-253204 (PTD 2)).

Following the installation of superconducting cables, there may be the case where the critical current of a superconducting cable is to be measured for the purpose of confirming cable characteristics through completion examination. PTD 1 teaches connecting one cable core that is the target of measurement with an additional cable core, and applying current at the outbound and return routes to measure the critical current of the target of measurement. By using the aforementioned additional cable core as a lead member in this measuring method, a long lead member formed of a material of normal conduction such as copper will not be required for the connection with a power supply even in the case where the two ends of the superconducting cable are located remote from each other after installation. This measuring method allows the critical current to be measured conveniently since increase in electrical resistance caused by the usage of a long lead material is eliminated, and a DC power supply of a large capacitance taking into account the electrical resistance is dispensable.

### CITATION LIST

### PATENT DOCUMENT

PTD 1: Japanese Patent Laying-Open No. 2006-329838
PTD 2: Japanese Patent Laying-Open No. 2005-253204

### SUMMARY OF INVENTION

### TECHNICAL PROBLEM

However, with regard to the coaxial superconducting cable including a plurality of (particularly, three or more) superconducting layers coaxially such as the aforementioned multiphase coaxial superconducting cable, no specific method to measure the critical current of each superconducting layer has been studied.

For example, consider the case where one of a plurality of superconducting layers in a coaxial superconducting cable is to be subject to measurement. Referring to PTD 1, a possible approach is to develop a current-applying round route with the superconducting layer that is the target of measurement corresponding to the outbound route and another superconducting layer corresponding to the return route. In this case, the aforementioned long lead material is not required. It can be expected that a system to measure critical current can be readily developed.

However, even if the aforementioned approach is employed, there is a case where the critical current of an arbitrary superconducting layer in a coaxial superconducting cable cannot be measured.

For the superconducting wire constituting each superconducting layer in a coaxial superconducting cable, the usage of wire of the same specification (material, size and the like) is advantageous from the standpoint of manufacturability of the wire as well as easiness in adjusting the winding condition and the like. However, it is to be noted that, in this case, the superconducting layer located at the outer circumferential side in one cable core has more lines of superconducting wire used as compared to that of a superconducting layer located at the inner circumferential side. Since the design value Ic_{layer} of critical current at a superconducting layer depends on the design value I_{Cwire} of critical current of the superconducting wire used (Ic_{wire} × used number of lines), the critical current design value Ic_{layer} outer of the superconducting layer located at the outer circumferential side becomes greater as compared to the critical current design value Ic_{layer inner} of the superconducting layer located at the inner circumferential side. In the case where the target of measurement is a superconducting layer located at the outer circumferential side which is used for the outbound route and a superconducting layer located at the inner circumferential side is used for the return route when the outer circumferential side critical current Ic_{layer} outer is greater than the inner circumferential side critical current Ic_{layer inner}, the current required for the measurement of critical current Ic_{layer} outer cannot be conducted to the outbound route and the return route due to the restriction by inner circumferential side critical current Ic_{layer} inner. In other words, the critical current of the target of measurement cannot be measured. Particularly in the case where the design value of critical current differs greatly when comparing each of superconducting layers in a coaxial superconducting cable, there may be a superconducting layer of which critical current cannot be actually measured.

In view of the foregoing an object of the present invention is to provide a critical current measuring method of a superconducting cable allowing critical current of an arbitrary superconducting layer in a coaxial superconducting cable to be measured.

### SOLUTION TO PROBLEM

The present invention achieves the aforementioned object by, in the measurement of critical current of a target of measurement by applying current in a round route with one of a plurality of superconducting layers in a coaxial superconducting cable as the target of measurement and another of the plurality of superconducting layers excluding the superconducting layer that is the target of measurement corresponding to a return route, setting a design value of critical current to satisfy a certain condition for the other superconducting layer corresponding to a return route.

A critical current measuring method of a superconducting cable of the present invention is directed to a method of measuring critical current of one superconducting layer as a target of measurement in a coaxial superconducting cable including a cable core having a plurality of superconducting layers arranged coaxially. In this measuring method, first at least one superconducting layer is selected from the plurality of superconducting layers excluding the superconducting layer that is the target of measurement. This selection is made such that the design value of critical current at the selected superconducting layer is greater than or equal to the design value of critical current at the superconducting layer that is the target of measurement. Then, at one end of the coaxial superconducting cable, the superconducting layer that is the target of measurement and the selected superconducting layer are electrically connected to develop a current-applying round route with the superconducting layer that is the target of measurement corresponding to an outbound route and the selected superconducting layer corresponding to a return route. Then, at the other end of the coaxial superconducting cable, a DC power supply is connected to the superconducting layer that is the target of measurement corresponding to the outbound route and to the selected superconducting layer corresponding to the return route, followed by applying DC current to the current-applying round route to measure the critical current of the superconducting layer that is the target of measurement.

The present invention developing a current-applying round route utilizing one of a plurality of (particularly, three or more) superconducting layers in the coaxial superconducting cable as the target of measurement as well as another superconducting layer is advantageous in that the aforementioned long lead member is not required, and critical current can be measured conveniently using a small power supply. Particularly, in the present invention, the superconducting layer to be used for the return route is selected based on the design value of critical current at the target of measurement as a reference. The value of current to be conducted for the measurement of critical current is not restricted by the value of the critical current of the return route. A value sufficiently high can be taken. Therefore, the present invention allows the critical current of an arbitrary superconducting layer in a coaxial superconducting cable to be measured.

One configuration of the present invention is directed to the return route including a plurality of superconducting layers.

By a configuration in which a plurality of superconducting layers constitute the return route, the critical current design value of the superconducting layers (sum) can readily be set greater than the critical current design value of the target of measurement (hereinafter, referred to as critical current Ic_{go})_{.} This configuration allows the critical current of the target of measurement to be measured reliably. This configuration substantially does not generate voltage at the return route by forming the return route by a plurality of superconducting layers and allows the voltage of only the outbound route to be measured. Therefore, the critical current of the superconducting layer that is the target of measurement corresponding to the outbound route can be measured accurately.

As one configuration of the present invention, the superconducting layer that is the target of measurement corresponding to the outbound route and the selected superconducting layer corresponding to the return route are provided in the same cable core, and the return route includes a plurality of superconducting layers located at an inner circumferential side than the superconducting layer that is the target of measurement.

Since the above configuration has the superconducting layer that is the target of measurement corresponding to the outbound route and the superconducting layer corresponding to the return route present in the same cable core, the current-applying round route can be formed more simply, superior in workability at the time of developing a measurement system. The configuration allows the critical current design value of the return route (sum) to be readily set greater than the critical current Ic_{go} of the target of measurement by developing the return route with a plurality of superconducting layers, despite the fact that the superconducting layers corresponding to the return route are located at the inner circumferential side of the cable core, i.e. the superconducting layer that is the target of measurement corresponding to the outbound route is located at the outer circumferential side of the cable core. The critical current of the target of measurement can be measured reliably.

One configuration of the present invention is directed to a multicore cable having a plurality of cable cores stored in one heat insulating pipe as the coaxial superconducting cable, wherein the cable core including the superconducting layer that is the target of measurement corresponding to the outbound route differs from the cable core including the selected superconducting layer corresponding to the return route.

The aforementioned configuration is advantageous in that the current-applying round route can be formed readily and is superior in workability at the time of developing a measurement system since the superconducting layer that is the target of measurement corresponding to the outbound route and the superconducting layer corresponding to the return route are stored in the same heat insulating pipe. Moreover, the configuration is advantageous in that a superconducting layer having a design value greater than the critical current Ic_{go} of the target of measurement can be selected readily with a great degree of freedom in selection since a superconducting layer corresponding to the return route can be selected from a plurality of cable cores.

### ADVANTAGEOUS EFFECTS OF INVENTION

A critical current measuring method of a superconducting cable of the present invention allows the critical current of an arbitrary superconducting layer in a coaxial superconducting cable to be measured.

### BRIEF DESCRIPTION OF DRAWINGS

Fig. 1 is a diagram to describe a critical current measuring method of a superconducting cable according to an embodiment.
Fig. 2 is a side sectional view schematically representing a coaxial superconducting cable.

### DESCRIPTION OF EMBODIMENTS

The present invention will be described in detail hereinafter with reference to the drawings. In the drawings, the same reference characters represent the same element. First, a coaxial superconducting cable subject to measurement will be described.

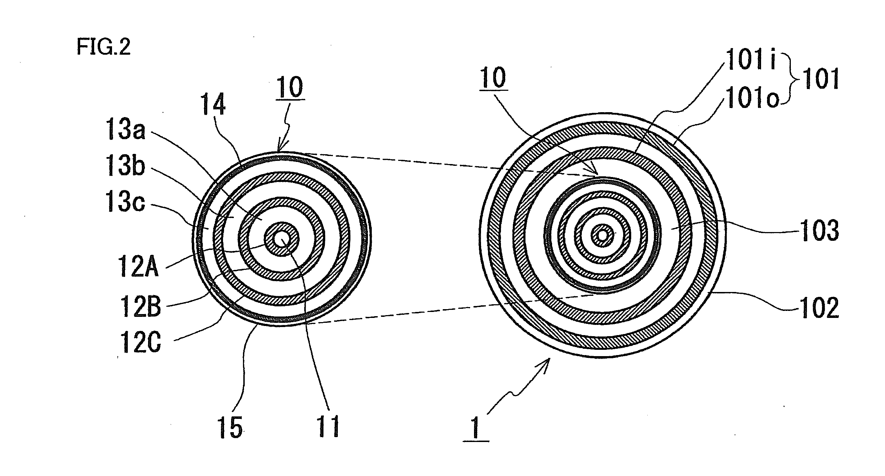

A coaxial superconducting cable 1 is, for example, a single core cable having one cable core 10 including a plurality of superconducting layers (here, superconducting layers 12A, 12B, and 12C) arranged coaxially, stored in one heat insulating pipe 101, as shown in Fig. 2.

Cable core 10 includes, for example, sequentially from the center, a former 11, a superconducting layer, an electrical insulating layer, a shield layer 14, and a protection layer 15.

Former 11 is used to support a superconducting layer, tensile strength material of the cable, as well as a current path to branch off faulty current at the time of an accident such as short-circuiting or grounding, and the like. When used as a current path, a solid or hollow body (pipe) formed of a material of normal conduction such as copper or aluminum can be suitably used for former 11. One example of a solid is a strand having a plurality of copper wires including an insulative cover such as of polyvinyl formal (PVF) or enamel interwoven. An insulative tape such as kraft paper or PPLP (product of Sumitomo Electric Industries, Ltd., registered trademark) can be wound around the circumference of former 11 to be provided a cushion layer (not shown).

Cable core 10 includes three superconducting layers 12A, 12B and 12C arranged coaxially. Each of superconducting layers 12A-12C includes a wire layer having a superconducting wire wound spirally as a single layer or multilayer. For the superconducting wire, a wire including an oxide superconducting phase can be cited. More specifically, there can be cited high-temperature superconducting wires such as RE type thin film wire, where RE is a rare earth element, including a rare earth type oxide superconducting phase such as REBa₂CU₃Oₓ called RE123 (for example, YBCO, HoBCO, GdBCO and the like) (wire including a thin film of the aforementioned superconducting phase on a metal substrate), or Bi type wire including Bi type oxide superconducting phase such as Bi₂Sr₂Ca₂Cu₃O_{10+δ} called Bi2223, and Ag or Ag alloy as the metal matrix. In the case where one superconducting layer takes a multilayer structure, an interlayer insulation layer having an insulative sheet such as kraft paper wound between the layers of each wire can be formed. In addition, carbon paper or the like can be wound appropriately immediately above or immediately below one superconducting layer to provide a semiconducting layer.

The used number of superconducting wires as well as the number of the layered wiring layers constituting each of superconducting layers 12A-12C are designed according to the desired electric power supply capacitance. In general, the critical current of the superconducting layer can be increased by increasing the used number of superconducting wires and layers. For example, a superconducting cable capable of supplying electric power of a large capacitance such as the rated current greater than or equal to 2 kA, or even greater than or equal to 4 kA, particularly greater than or equal to 5 kA, can be achieved. In the case where coaxial superconducting cable 1 is used for the electric transmission of 3-phase alternating current and each of superconducting layers 12A-12C is used for the electric transmission of each phase, the used number and layers of each of superconducting layers 12A-12C should be designed according to the electrical transmitting capacitance of each phase.

Although the superconducting wire constituting each of superconducting layers 12A-12C can be formed with wire of different specification (material, size, critical current property), using wire of the same specification is advantageous in that the manufacturability of the wire is superior and adjustment of the winding conditions can be readily adjusted, leading to superior cable production. In the case where each of superconducting layers 12-12C is formed of wire of the same specification, the number of superconducting wires used constituting the superconducting layer located at an outer circumferential side in cable core 10 (here, superconducting layer 12C) is allowed to be equal to or greater than the number of superconducting wire used constituting the superconducting layer located at an inner circumferential side (here, superconducting layers 12A and 12B). By adjusting the width of the superconducting wire, the distance between wires adjacent radially at the wire layer and the like, the used number of superconducting wires at each superconducting layer can be set equal.

At cable core 10, electrical insulating layers 13a, 13b and 13c are provided coaxially between superconducting layers 12A and 12B, between superconducting layers 12B and 12C, and at the outer circumference of superconducting layer 12C, respectively. Electrical insulating layers 13a-13c can be formed by winding an insulative tape such as of kraft paper or a semi-synthetic insulative sheet such as PPLP (registered trademark). Electrical insulating layers 13a-13c should be provided to have the voltage resistant property required for phase-to-phase insulation, when superconducting layers 12A - 12C are to be used for 3-phase alternating current electric transmission.

Shield layer 14 may include at least one of a superconducting shield layer and normal conducting shield layer. A superconducting shield layer can be formed by winding the aforementioned superconducting wire spirally, for example. A normal conducting shield layer can be formed by winding a metal tape of material of normal conduction such as copper, for example. Shield layer 14 can be used as a magnetic shield layer during the operation of coaxial superconducting cable 1. The normal conducting shield layer can be used for a current path that branches off induction current at the time of the aforementioned faulty current.

Protection layer 15 functions to mechanically protect the shield layer (particularly, the superconducting shield layer). Protection layer 15 may be formed by winding an insulative tape such as of kraft paper or semi-synthetic insulating sheet such as PPLP (registered trademark).

Heat insulating pipe 101 is a double layered pipe including an inner pipe 101i and an outer pipe 101o. A vacuum insulating structure having the space between inner pipe 101i and outer pipe 101o evacuated is typical. At the time of operation, inner pipe 101i is filled with a coolant 103 such as liquid nitrogen to maintain the superconducting layer and the superconducting shield layer in a superconducting state. A configuration in which a heat insulator such as superinsulation (not shown) is provided between inner pipe 101i and outer pipe 101o, or a spacer (not shown) maintaining the distance between pipes 101i and 101o can be used. Corrosion resistance can be improved by providing an anti-corrosion layer 102 such as polyvinyl chloride (PVC) at the outer circumference of outer pipe 101o.

### (First Embodiment)

A method of measuring critical current of a superconducting layer in a coaxial superconducting cable 1 having the structure set forth above will be described hereinafter. Description is based on the case where a superconducting layer 12C located at the outer circumferential side of cable core 10 is taken as the target of measurement.

First, at least one superconducting layer (excluding superconducting layer 12C taken as the target of measurement) is selected from cable core 10 of coaxial superconducting cable 1. The present invention is particularly characterized in that selection is made such that the critical current design value of the selected superconducting layer (hereinafter, referred to as critical current Icᵣₑₜᵤᵣₙ) is greater than or equal to the critical current Ic_{go} of superconducting layer 12C that is the target of measurement.

Assuming that the critical current design value of each of superconducting layers 12A, 12B and 12C is 3000A, 4000A and 5000A, respectively, critical current Icᵣₑₜᵤᵣₙ of the selected superconducting layer, whichever of superconducting layers 12A and 12B is selected, will not become greater than or equal to 5000A since the critical current Ic_{go} of the target of measurement is 5000A. If both of superconducting layers 12A and 12B are selected, critical current Icᵣₑₜᵤᵣₙ (here, the sum) will become 3000A+ 4000A = 7000A, which is greater than the critical current Ic_{go} of the target of measurement, i. e. 5000A. Therefore, in the present example, both of superconducting layers 12A and 12B are selected.

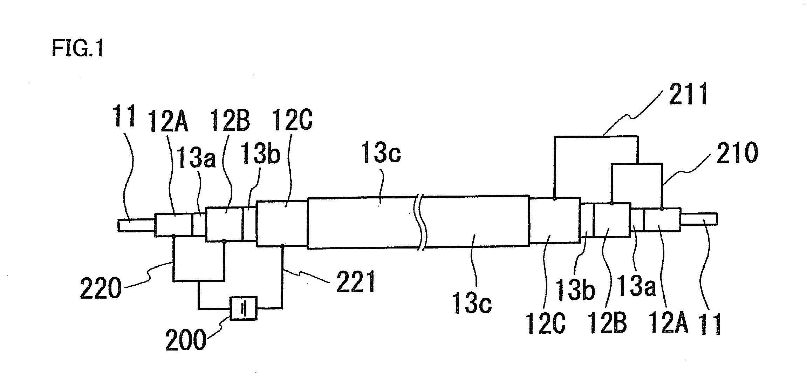

Then, a current-applying round route is developed, taking superconducting layer 12C that is the target of measurement for the outbound route and both of selected superconducting layers 12A and 12B for the return route. Specifically, as shown in Fig. 1, both end sides of the cable core are stage-stripped to expose each of superconducting layers 12A, 12B and 12C. Then, at one end of coaxial superconducting cable 1 (right side in Fig. 1), superconducting layers 12A and 12B are electrically connected, and both superconducting layers 12A and 12B are electrically connected with superconducting layer 12C that is the target of measurement. For this connection, lead members 210 and 211 can be used. Specifically, superconducting layers 12A and 12B are connected by lead member 210. Superconducting layer 12C and lead member 210 are connected by lead member 211. Lead members 210 and 211 as well as lead members 220, 221 that will be described afterwards are formed of a material of normal conduction such as copper or copper alloy, or of an appropriate combination of the aforementioned superconducting wire. For example, a terminal connector (terminal container) is connected at either end of superconducting cable 1, and superconducting layers 12A, 12B and 12C may be led out from the low temperature region to the normal temperature region by different leads. For example, connection between superconducting layers 12A and 12B may be effected by connecting the tips of the current lead that are normal temperature regions together with a copper bar.

Then, at the other end of coaxial superconducting cable 1 (left side in Fig. 1), a DC power supply 200 is connected at the outbound route and return route to allow current application along the developed current-applying round route. Here, both superconducting layers 12A and 12B corresponding to the return route are electrically connected by lead member 220; superconducting layer 12C corresponding to the outbound route is connected to lead member 221; and DC power supply 200 is connected to lead members 220 and 221.

A commercially available product may be used for DC power supply 200. For DC power supply 200, a device having the mechanism of allowing the change rate of applying current to be controlled may be used, or a commercially available sweeper device (not shown) capable of controlling the change rate can be arranged together with DC power supply 200. Moreover, connecting a recording device including storage means for recording the measurement data from DC power supply 200 (mainly, applied current) to DC power supply 200 is advantageous for the operator to readily identify the measurement result.

Additionally, measurement means (not shown) for measuring the voltage between the ends of superconducting layers 12A and 12B and the end of superconducting layer 12C is attached at the end of cable core 10. Attaching the storage means, recording means and the like of measurement data at the end of cable core 10 is advantageous for the operator to readily identify the measurement result.

Upon developing a measurement system set forth above, DC current is supplied at a constant change rate from DC power supply 200 to superconducting layer 12C for the outbound route and superconducting layers 12A and 12B for the return route constituting the current-applying round route, and the critical current at the outbound route is measured. The DC current flows from lead member 221 to superconducting layer 12C, and further to lead member 211 to be branched off at lead member 210 to flow to superconducting layers 12A and 12B. Preferably, current of the same level flows to each of superconducting layers 12A and 12B (1/2 of the applied current to each) in an ideal state. The divided current through superconducting layers 12A and 12B is combined at the side of DC power supply 200 through lead member 220.

The critical current of superconducting layer 12C is obtained as set forth below. The voltage signal (potential difference) between superconducting layer 12C and superconducting layers 12A, 12B is measured. The relationship between the current and voltage is obtained. From the obtained current-voltage characteristic, the current at which the electric field of 1 ·V/cm (= 0.1 mV/m) is generated is obtained, which is taken as the critical current.

In the measurement of the critical current of one of a plurality of superconducting layers in a coaxial superconducting cable, development of a current-applying round route utilizing another superconducting layer allows a long lead member to be dispensed with. This means that a power supply of large capacitance to ensure voltage to be generated at the long lead member does not have to be used. Therefore, in the first embodiment, the critical current of the superconducting layer taken as the target of measurement can be readily measured using a power supply of small capacitance. Particularly, by selecting a superconducting layer for the return route such that the critical current design value thereof is greater than or equal to the design value I_{Cgo} of the critical current at superconducting layer 12C that is the target of measurement corresponding to the outbound route in the first embodiment, the current flowing through the superconducting layer corresponding to the return route will not exceed the design value of the critical current of the relevant superconducting layer (becomes less than or equal to the value of the current that can be applied to the return route). Therefore, in the first embodiment, the value of the current to be applied for the purpose of measuring critical current can be set high enough to ensure the measurement of critical current of the target. The critical current of any superconducting layer, whichever is taken as the target of measurement from the entire superconducting layers, can be measured.

Moreover, by developing the return route with a plurality of superconducting layers although the superconducting layer that is the target of measurement is located at an outer circumferential side and the superconducting layers for the return route are located at the inner circumferential side, the sum of the design values of the critical current at the return route can be set greater than or equal to critical current design value I_{Cgo}. Therefore, the critical current of the target of measurement can be measured reliably in the first embodiment.

In addition, by developing the return route with a plurality of superconducting layers, the current is branched off to the relevant plurality of superconducting layers, so that voltage is not substantially generated at the return route. Therefore, the critical current can be measured accurately since the voltage at the superconducting layer taken as the target of measurement for the outbound route can be measured appropriately.

### (Modification 1)

The aforementioned RE type thin film wire and Bi type wire both show the tendency of having the critical current reduced when the magnetic field is applied perpendicular to the surface (when the magnetic field is applied in the thickness direction of the superconducting wire), as compared to the case where the magnetic field is applied parallel to the surface. Therefore, in the case where superconducting layer 12C located at the outer circumferential side of cable core 10 is taken as the target of measurement and corresponds to the outbound route, whereas superconducting layers 12A and 12B located at the inner side correspond to the outbound route, the critical current can be measured further accurately by correcting the amount of reduction in the critical current caused by the magnetic field formed by superconducting layers 12A and 12B corresponding to the return route.

### (Modification 2)

Although superconducting layer 12C is taken as the target of measurement in the first embodiment, the critical current of superconducting layer 12A or superconducting layer 12B of course can also be measured. In the case where superconducting layer 12A is to be taken as the target of measurement when the design value of the critical current of each of superconducting layers 12A, 12B and 12C is 3000A, 4000A and 5000A, respectively, superconducting layer 12B, for example, can be used for the return route. In this case, at one end of coaxial superconducting cable 1, superconducting layers 12A and 12B are to be electrically connected via a lead member. At the other end of coaxial superconducting cable 1, superconducting layers 12A and 12B are to be connected to DC power supply 200 appropriately via a lead member. In the case where superconducting layer 12B is to be taken as the target of measurement, superconducting layer 12C can be used for the return route. In this case, at one end of coaxial superconducting cable 1, superconducting layers 12B and 12C are to be electrically connected via a lead member. At the other end of coaxial superconducting cable 1, superconducting layers 12B and 12C are to be connected to DC power supply 200 appropriately via a lead member.

In either case, the critical current design value of the superconducting layer corresponding to the return route is sufficiently greater than the critical current design value of the superconducting layer that is the target of measurement corresponding to the outbound route. Thus, the critical current of any of superconducting layers 12A and 12B can be measured accurately.

In the case where there is no great difference between critical current I_{Cgo} of the superconducting layer taken as the target of measurement and the critical current design value of the other superconducting layer, an arbitrary superconducting layer can be used for the return route.

### (Second Embodiment)

The first embodiment is based on the case where the superconducting cable taken as the target of measurement is a single core cable. The measuring method of the present invention is also applicable to a multicore cable including a plurality of cable cores (having the configuration described in the first embodiment) in one heat insulating pipe. In this case, for an arbitrary cable core in the multicore coaxial superconducting cable, an arbitrary superconducting cable can be taken as the target of measurement and for the outbound route while at least one another superconducting layer in the same cable core can be taken for the return route (provided that a superconducting layer satisfying critical current Ic_{go} ≤ critical current Icᵣₑₜᵤᵣₙ (the sum in the case of a plurality of layers) is selected for the return route).

Alternatively, for an arbitrary cable core in a multicore coaxial superconducting cable, an arbitrary superconducting layer can be taken as the target of measurement and for the outbound route, while at least one superconducting layer in another cable core can be taken for the return route, or at least one another superconducting layer in the same cable core as well as at least one superconducting layer in another cable core can be taken for the return route (provided that a superconducting layer satisfying critical current Ic_{go} ≤ critical current Icᵣₑₜᵤᵣₙ (the sum in the case of a plurality of layers) is selected for the return route).

The aforementioned configuration has a great degree of freedom of selection for the superconducting layer corresponding to the return route, and the critical current of an arbitrary superconducting layer can be measured.

The present invention is not limited to the embodiment set forth above, and may be modified appropriately without departing from the spirit of the present invention. For example, the number of superconducting layers in one cable core, the number of cable cores in one heat insulating pipe, and the like may be modified.

### INDUSTRIAL APPLICABILITY

The critical current measuring method of a superconducting cable of the present invention is suitably applicable to measuring critical current in the completion examination of a superconducting cable following insulation. The target of measurement is not limited to a superconducting cable for multiphase alternating current, and may be applied to a superconducting cable for direct current.

### REFERENCE SIGNS LIST

1 coaxial superconducting cable; 10 cable core; 11 former; 12A, 12B, 12C superconducting layer; 13a, 13b, 13c electrical insulating layer; 14 shield layer; 15 protection layer; 101 heat insulating pipe; 101i inner pipe; 101o outer pipe; 102 anti-corrosion layer; 103 coolant; 210, 211, 220, 221 lead member; 200 direct current power supply.

## Claims

1. A critical current measuring method of a coaxial superconducting cable including a cable core having a plurality of superconducting layers arranged coaxially, comprising the steps of:
when measuring critical current of one superconducting layer as a target of measurement, selecting at least one from the plurality of superconducting layers excluding the superconducting layer that is the target of measurement, the selection being made such that a design value of the critical current at said selected superconducting layer is greater than or equal to the design value of the critical current of said superconducting layer that is the target of measurement,
at one end of said coaxial superconducting cable, electrically connecting said superconducting layer that is the target of measurement and said selected superconducting layer, and developing a current-applying round route with said superconducting layer that is the target of measurement corresponding to an outbound route and said selected superconducting layer corresponding to a return route, and
at the other end of said coaxial superconducting cable, connecting a direct current power supply to said superconducting layer that is the target of measurement corresponding to the outbound route and to said selected superconducting layer corresponding to the return route, and applying DC current to said current-applying round route to measure the critical current of said superconducting layer that is the target of measurement.

2. The critical current measuring method of a superconducting cable according to claim 1, wherein said return route includes a plurality of superconducting layers.

3. The critical current measuring method of a superconducting cable according to claim 2, wherein the design value of the critical current of said selected superconducting layer is a sum of the design value of critical current of each of said plurality of superconducting layers.

4. The critical current measuring method of a superconducting cable according to any one of claims 1-3, wherein
said superconducting layer that is the target of measurement corresponding to the outbound route and said selected superconducting layer corresponding to the return route are provided at a same cable core, and
said return route includes a plurality of superconducting layers located at an inner circumferential side than said superconducting layer that is the target of measurement.

5. The critical current measuring method of a superconducting cable according to any one of claims 1-3, wherein
said coaxial superconducting cable is a multicore cable having a plurality of cable cores stored in one heat insulating pipe, and
a cable core including said superconducting layer that is the target of measurement corresponding to the outbound route differs from a cable core including said selected superconducting layer corresponding to the return route.
